# EUROPEAN PATENT APPLICATION

(11) **EP 4 797 045 A2**
(43) Date of publication of application: **26.08.2026**
(21) Application number: 26175208.3
(22) Date of filing: 15.02.2023
(51) Int. Cl.: G06F 1/18

(54) **HEAT-RADIATING STRUCTURE AND ELECTRONIC DEVICE COMPRISING SAME**

(30) Priority: 16.02.2022 KR 20220020363; 18.05.2022 KR 20220060952
(62) Document number(s) of the earlier application(s) in accordance with Art. 76 EPC: 23756634.4 / 4 474 946
(71) Applicant: Samsung Electronics Co., Ltd., Suwon-si, Gyeonggi-do 16677 (KR)
(72) Inventor: AHN, Joseph, 16677 Suwon-si (KR); LEE, Youngchul, 16677 Suwon-si (KR); KIM, Taehyeong, 16677 Suwon-si (KR); MOON, Hongki, 16677 Suwon-si (KR); PARK, Jongkil, 16677 Suwon-si (KR)
(74) Representative: HGF

(57) **Abstract**

An electronic device according to various embodiments of the present disclosure comprises: a housing; a display arranged in the housing; a support member which supports the display, and which comprises a first surface facing the display, a second surface facing the opposite direction of the first surface, and a first opening penetrating at least one portion of the first surface and the second surface; a battery which is arranged on the second surface of the support member, and which has at least one portion facing the first opening; a printed circuit board arranged on the second surface of the support member and spaced from the battery; and a heat-radiating member configured to mediate heat transfer between the display and the printed circuit board, wherein the heat-radiating member comprises a first area having least one portion overlappingly arranged on the first surface, and a second area which is coupled to the first area and which has at least one portion arranged in the first opening, and the at least one portion of the first area can be coupled to the support member by means of laser welding. Other various embodiments are possible.

## Description

### [Technical Field]

Various embodiments disclosed in this document relate to electronic devices, for example, a heat-radiating structure and an electronic device including the same.

### [Background Art]

Electronic devices may indicate devices that perform specific functions according to installed programs, such as home appliances, electronic notebooks, portable multimedia players, mobile communication terminals, tablet PCs, video/audio devices, desktop/laptop computers, or vehicle navigation devices. For example, these electronic devices may output stored information as sound or video. As the degree of integration of electronic devices increases and high-speed and high-capacity wireless communication becomes more common, a variety of functions may be installed in a single electronic device such as a mobile communication terminal, nowadays. For example, in addition to communication functions, entertainment functions such as games, multimedia functions such as music/video playback, communication and security functions for mobile banking, and schedule management and electronic wallet functions are being integrated into one electronic device. These electronic devices are becoming smaller so that users are able to conveniently carry them.

### [Detailed Description of the Invention]

### [Technical Problem]

There has been a trend toward high-density packaging of various electrical components in electronic devices in order to implement thinner or smaller electronic devices while providing various functions. In addition, the electronic device may include at least one heat source (e.g., a processor) that generates heat during use among the electrical components used to implement such functions.

The heat generated from the heat source needs to be transferred to other areas or electrical components (e.g., a display) of the electronic device, which have larger heat capacity, and this may require a heat transfer path.

In general, electronic devices may be provided with a heat-radiating structure or heat-radiating member for a heat transfer path. Such a heat-radiating member may be attached to the inner structure (e.g., a bracket) of the electronic device using an adhesive member such as double-sided tape. In the case where the heat-radiating member is attached to the inner structure by an adhesive member, the thickness of the adhesive member itself may increase the overall thickness of the electronic device. Additionally, the adhesive member may be easily worn or damaged during use, causing the heat-radiating member to separate from the bracket.

According to various embodiments of the disclosure, a heat-radiating structure capable of transferring heat generated from a heat source or printed circuit board to a display and an electronic device including the same may be provided.

However, the problems to be solved by the disclosure are not limited to the above-mentioned problems, and may be determined in various ways without departing from the spirit and scope of the disclosure.

### [Technical Solution]

According to various embodiments of the disclosure, an electronic device may include: a housing; a display disposed in the housing; a support member configured to support the display and including a first surface facing the display, a second surface facing in the opposite direction to the first surface, and a first opening formed to penetrate at least a portion of the first surface and the second surface; a battery disposed on the second surface of the support member and having at least a portion facing the first opening; a printed circuit board disposed on the second surface of the support member and spaced apart from the battery; and a heat-radiating member configured to mediate heat transfer between the display and the printed circuit board, and including a first area having at least a portion disposed to overlap the first surface and a second area coupled to the first area and having at least a portion disposed in the first opening, wherein at least a portion of the first area may be coupled to the support member by laser welding.

According to various embodiments of the disclosure, an electronic device may include: a housing; a display disposed in the housing; a support member configured to support the display and including a first surface facing the display, a second surface facing in the opposite direction to the first surface, and a first opening formed to penetrate at least a portion of the first surface and the second surface; a battery disposed on the second surface of the support member; a printed circuit board disposed on the second surface of the support member and spaced apart from the battery; and a heat-radiating member configured to mediate heat transfer between the display and the printed circuit board, and including a first area having at least a portion disposed to overlap the first surface and a second area coupled to the first area and having at least a portion disposed in the first opening, wherein the first opening may include a (1-1)th opening disposed to face the battery, and a (1-2)th opening extending from the (1-1)th opening and disposed to face the printed circuit board, and wherein at least a portion of the first area may be coupled to the support member by laser welding, and the laser welding may include at least one of wobble laser welding and spot laser welding.

According to various embodiments of the disclosure, a heat-radiating structure of the electronic device may include: a first electrical component; a plurality of second electrical components spaced apart from the first electrical component; a support member including a first surface disposed to face the first electrical component and a second surface disposed to face the plurality of second electrical components; and a heat-radiating member configured to transfer heat generated from at least one of the plurality of second electrical components to the first electrical component, wherein at least a portion of the heat-radiating member may be coupled to at least a portion of the first surface by laser welding.

### [Advantageous Effects]

According to various embodiments of the disclosure, the heat generated from the heat source may be effectively dispersed by the heat-radiating member effectively dissipating heat generated from the heat source.

According to various embodiments of the disclosure, the thickness of the electronic device may be reduced by coupling the heat-radiating member directly to the support member by laser welding.

The effects obtainable from the disclosure are not limited to the effects mentioned above, and other effects not mentioned may be clearly understood by those skilled in the art to which the disclosure pertains from the description below.

### [Brief Description of Drawings]

FIG. 1 is a block diagram of an electronic device in a network environment according to various embodiments.
FIG. 2 is a front perspective view of an electronic device according to various embodiments of the disclosure.
FIG. 3 is a rear perspective view of an electronic device according to various embodiments of the disclosure.
FIG. 4 is an exploded perspective view of an electronic device according to various embodiments of the disclosure.
FIG. 5A is a front view of an electronic device according to various embodiments of the disclosure.
FIG. 5B is a rear view of an electronic device according to various embodiments of the disclosure.
FIG. 6A is a front perspective view illustrating the exploded state of an electronic device and a heat-radiating member according to various embodiments of the disclosure.
FIG. 6B is a rear perspective view illustrating the exploded state of an electronic device and a heat-radiating member according to various embodiments of the disclosure.
FIG. 7 is a cross-sectional view taken along line A-A' in FIG. 5A according to various embodiments of the disclosure.
FIG. 8 is a cross-sectional view taken along line B-B' in FIG. 5A according to various embodiments of the disclosure.
FIG. 9 is a cross-sectional view taken along line C-C' in FIG. 5A according to various embodiments of the disclosure.
FIG. 10 is a cross-sectional view illustrating an electronic device and a heat-radiating member according to various embodiments of the disclosure.
FIG. 11A is a diagram illustrating a state before a heat-radiating member is laser-welded according to various embodiments of the disclosure.
FIG. 11B is a diagram illustrating a state after a heat-radiating member is laser-welded according to various embodiments of the disclosure.
FIG. 12A is a diagram illustrating a state after a heat-radiating member is laser-welded according to various embodiments of the disclosure.
FIG. 12B is a diagram illustrating a state after a heat-radiating member is laser-welded according to various embodiments of the disclosure.
FIG. 12C is a diagram illustrating a state after a heat-radiating member is laser-welded according to various embodiments of the disclosure.
FIG. 12D is a diagram illustrating a state after a heat-radiating member is laser-welded according to various embodiments of the disclosure.
FIG. 12E is a diagram illustrating a state after a heat-radiating member is laser-welded according to various embodiments of the disclosure.
FIG. 13A is a conceptual diagram illustrating wobble laser welding according to various embodiments of the disclosure.
FIG. 13B is a conceptual diagram illustrating wobble laser welding and spot laser welding according to various embodiments of the disclosure.
FIG. 13C is a conceptual diagram illustrating wobble laser welding and spot laser welding according to various embodiments of the disclosure.
FIG. 14 is a plan view of an electronic device according to various embodiments of the disclosure.
FIG. 15A is a plan view of a housing according to various embodiments of the disclosure.
FIG. 15B is a plan view of a housing according to various embodiments of the disclosure.
FIG. 16 is a perspective view of an electronic device according to various embodiments of the disclosure.
FIG. 17 is a diagram illustrating a heat-radiating member according to various embodiments of the disclosure.

### [Mode for Carrying out the Invention]

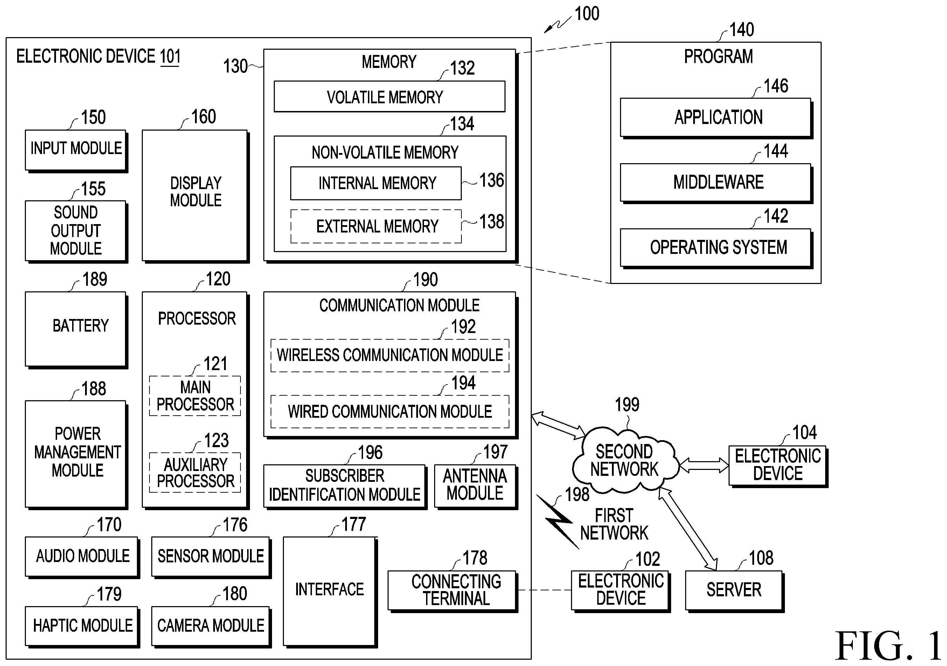

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{TM}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

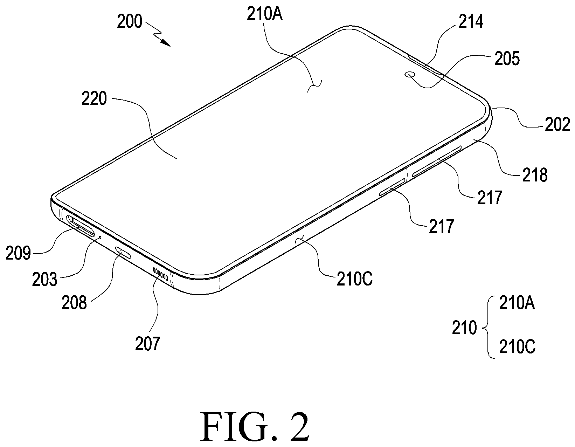

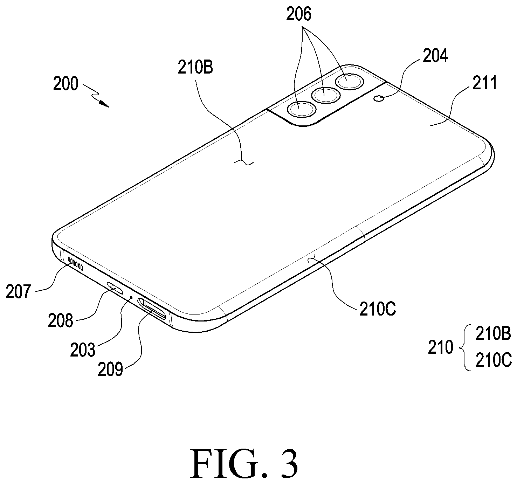

FIG. 2 is a front perspective view of an electronic device according to various embodiments of the disclosure. FIG. 3 is a rear perspective view of an electronic device according to various embodiments of the disclosure.

Referring to FIGS. 2 and 3, an electronic device 200 according to an embodiment may include a housing 210 including a front surface 210A, a rear surface 210B, and a side surface 210C surrounding a space between the front surface 210A and the rear surface 210B. In another embodiment (not shown), the housing 210 may refer to a structure forming some of the front surface 210A in FIG. 2, and the rear surface 210B and side surface 210C in FIG. 3. For example, the housing 210 may include a front plate 202 and a rear plate 211. According to an embodiment, at least a portion of the front surface 210A may be formed by a front plate 202 (e.g., a glass plate or polymer plate including various coating layers) that is substantially transparent. The rear surface 210B may be formed by a rear plate 211. The rear plate 211 may be formed of, for example, glass, ceramic, polymer, metal (e.g., titanium (Ti), stainless steel (STS), aluminum (Al), and/or magnesium (Mg)), or a combination of at least two of the above materials. The side surface 210C may be formed by a side bezel structure (or "side member") 218 coupled to the front plate 202 and the rear plate 211 and including metal and/or polymer. In a certain embodiment, the rear plate 211 and the side bezel structure 218 may be integrally formed and may include the same material (e.g., glass, a metal material such as aluminum, or ceramic). According to another embodiment, the front surface 210A and/or the front plate 202 may be interpreted as part of the display 220.

According to an embodiment, the electronic device 200 may include at least one or more of a display 220, audio modules 203, 207, and 214 (e.g., the audio module 170 in FIG. 1), a sensor module (e.g., the sensor module 176 in FIG. 1), camera modules 205 and 206 (e.g., the camera module 180 in FIG. 1), a key input device 217 (e.g., the input module 150 in FIG. 1), and connector holes 208 and 209 (e.g., the connection terminal 178 in FIG. 1). In a certain embodiment, the electronic device 200 may exclude at least one (e.g., the connector hole 209) of the elements or further include other elements. According to an embodiment, the display 220 may be exposed, for example, through a substantial portion of the front plate 202.

According to an embodiment, the surfaces (or the front plate 202) of the housing 210 may include a screen display area that is formed as the display 220 is visually exposed. For example, the screen display area may include the front surface 210A.

In another embodiment (not shown), the electronic device 200 may include a recess or opening formed in a portion of the screen display area (e.g., the front surface 210A) of the display 220, and may include at least one or more of an audio module 214, a sensor module (not shown), a light-emitting device (not shown), and a camera module 205, which are aligned with the recess or opening. In another embodiment (not shown), at least one or more of an audio module 214, a sensor module (not shown), a camera module 205 (e.g., under display camera (UDC)), a fingerprint sensor (not shown), and a light-emitting device (not shown) may be included on the back side of the screen display area of the display 220.

In another embodiment (not shown), the display 220 may be coupled to or adjacent to a touch detection circuit, a pressure sensor capable of measuring the intensity (pressure) of touch, and/or a digitizer that detects a magnetic field-type stylus pen.

In a certain embodiment, at least a portion of the key input device 217 may be disposed on the side bezel structure 218.

According to an embodiment, the audio modules 203, 207, and 214 may include, for example, a microphone hole 203 and speaker holes 207 and 214. A microphone for obtaining external sound may be disposed inside the microphone hole 203, and in a certain embodiment, a plurality of microphones may be disposed to detect the direction of sound. The speaker holes 207 and 214 may include an external speaker hole 207 and a receiver hole 214 for a call. In a certain embodiment, the speaker holes 207 and 214 and the microphone hole 203 may be implemented as one hole, or a speaker may be included without the speaker holes 207 and 214 (e.g., a piezo speaker).

According to an embodiment, a sensor module (not shown) may generate an electrical signal or data value corresponding to an internal operation state of the electronic device 200 or an external environmental state. The sensor module (not shown) may include, for example, a first sensor module (not shown) (e.g., a proximity sensor) and/or a second sensor module (not shown) (e.g., a fingerprint sensor) disposed on the front surface 210A of the housing 210. The sensor module (not shown) may include a third sensor module (not shown) (e.g., an HRM sensor) and/or a fourth sensor module (not shown) (e.g., a fingerprint sensor) disposed on the rear surface 210B of the housing 210. In a certain embodiment (not shown), the fingerprint sensor may be disposed on the rear surface 210B, as well as the front surface 210A (e.g., the display 220) of the housing 210. The electronic device 200 may further include a sensor module that is not shown, for example, at least one of a gesture sensor, a gyro sensor, an atmosphere pressure sensor, a magnetic sensor, an acceleration sensor, a grip sensor, a color sensor, an infrared (IR) sensor, a biometric sensor, a temperature sensor, a humidity sensor, and an illuminance sensor.

According to an embodiment, the camera modules 205 and 206 may include, for example, a front camera module 205 disposed on the front surface 210A of the electronic device 200, and a rear camera module 206 and/or a flash 204 disposed on the rear surface 210B. The camera modules 205 and 206 may include one or more lenses, an image sensor, and/or an image signal processor. The flash 204 may include, for example, a light-emitting diode or a xenon lamp. In a certain embodiment, two or more lenses (an infrared camera, a wide-angle lens, and a telephoto lens) and image sensors may be disposed on one side of the electronic device 200.

According to an embodiment, the key input device 217 may be disposed on the side surface 210C of the housing 210. In another embodiment, the electronic device 200 may exclude part or entirety of the above-mentioned key input device 217, and the excluded key input device 217 may be implemented in another form such as soft keys on the display 220.

According to an embodiment, a light-emitting device (not shown) may be disposed on, for example, the front surface 210A of the housing 210. For example, the light-emitting device (not shown) may provide status information of the electronic device 200 in the form of light. In another embodiment, the light-emitting device (not shown) may provide, for example, a light source linked to the operation of the front camera module 205. The light-emitting device (not shown) may include, for example, LEDs, IR LEDs, and/or xenon lamps.

According to an embodiment, the connector holes 208 and 209 may include, for example, a first connector hole 208 that receives a connector (e.g., a USB connector) for transmitting and receiving power and/or data to and from an external electronic device and a connector (e.g., an earphone jack) for transmitting and receiving an audio signal to and from an external electronic device, and a second connector hole 209 that receives a storage device (e.g., a subscriber identification module (SIM) card). According to an embodiment, the first connector hole 208 and/or the second connector hole 209 may be omitted.

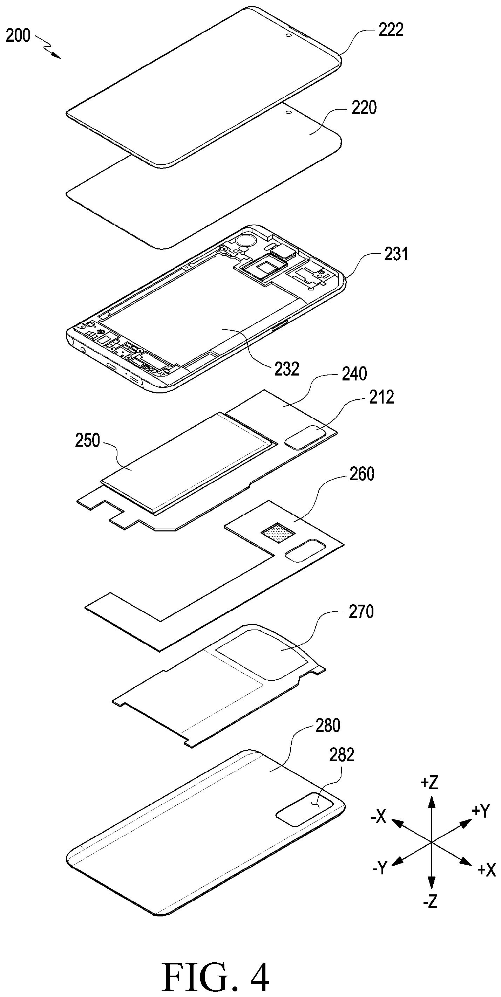

FIG. 4 is an exploded perspective view of an electronic device according to various embodiments of the disclosure.

In the following drawings, a rectangular coordinate system may be shown in the drawings for convenience of explanation. The depicted X-axis direction may be defined and interpreted as the width direction of the electronic device and its components, and the depicted Y-axis direction may be defined and interpreted as the longitudinal direction of the electronic device and its components, and the depicted Z-axis direction may be defined and interpreted as the thickness direction of the electronic device and its components.

Referring to FIG. 4, the electronic device 200 (e.g., the electronic device 200 in FIGS. 2 and 3) may include at least one of a front plate 222 (e.g., the front plate 202 in FIG. 2), a display 220 (e.g., the display 220 in FIG. 2), a bracket 232 (e.g., a front support member), a printed circuit board 240, a battery 250, a rear case 260 (e.g., a rear support member), an antenna 270, and a rear plate 280 (e.g., the rear plate 211 in FIG. 3). In a certain embodiment, the electronic device 200 may exclude at least one (e.g., the rear case 260) of the elements or may further include other elements. At least one of the elements of the electronic device 200 may be the same as or similar to at least one of the elements of the electronic device 200 in FIG. 2 or 3, and redundant descriptions thereof will be omitted below.

According to an embodiment, the support member 232 (e.g., a bracket) may be disposed inside the electronic device 200 and connected to the side bezel structure 231 or formed integrally with the side bezel structure 231. The support member 232 may be formed of, for example, a metal material and/or a non-metal material (e.g., polymer). The support member 232 may accommodate the display 220 on one side and the printed circuit board 240 on the other side. The printed circuit board 240 may have a processor (e.g., the processor 120 in FIG. 1), memory (e.g., the memory 130 in FIG. 1), and/or an interface (e.g., the interface 177 in FIG. 1) mounted thereon.

According to an embodiment, the battery 250 is a device for supplying power to at least one element (e.g., the camera module 212) of the electronic device 200, and may include, for example, a non-rechargeable primary battery, a rechargeable secondary battery, or a fuel cell. At least a portion of the battery 250 may be disposed, for example, on substantially the same plane as the printed circuit board 240. The battery 250 may be disposed integrally inside the electronic device 200, or may be configured to be detachable from the electronic device 200.

According to an embodiment, the rear case 260 may be disposed between the printed circuit board 240 and the antenna 270. For example, the rear case 260 may include one side to which at least one of the printed circuit board 240 or the battery 250 is coupled, and the other side to which the antenna 270 is coupled.

According to an embodiment, the antenna 270 may be disposed between the rear plate 280 and the battery 250. The antenna 270 may include, for example, a near-field communication (NFC) antenna, a wireless charging antenna, and/or a magnetic secure transmission (MST) antenna. For example, the antenna 270 may perform short-range communication with an external device or wirelessly transmit and receive power required for charging. For example, the antenna 270 may include a coil for wireless charging. In another embodiment, the antenna structure may be formed by a portion or a combination of the side bezel structure 231 and/or the bracket 232.

According to various embodiments, the electronic device 200 may include a camera module 212 disposed in a housing (e.g., the housing 210 in FIG. 2). According to an embodiment, the camera module 212 may be a rear camera module (e.g., the camera module 206 in FIG. 3) disposed on the bracket 232 to obtain images of subjects located at the rear (e.g., in the Z-axis direction) of the electronic device 200. According to an embodiment, at least a portion of the camera module 212 may be exposed to the outside of the electronic device 200 through an opening 282 formed in the rear plate 280.

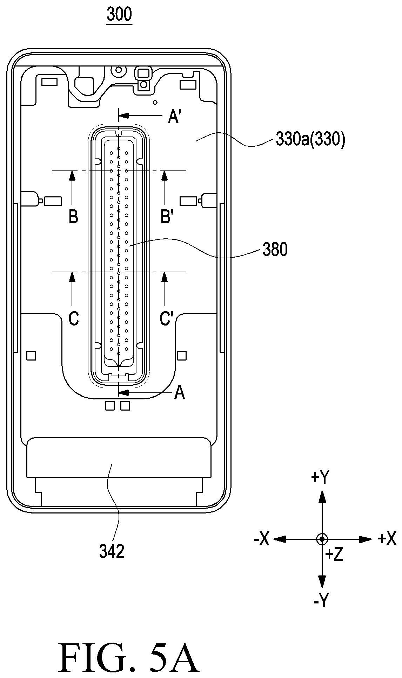

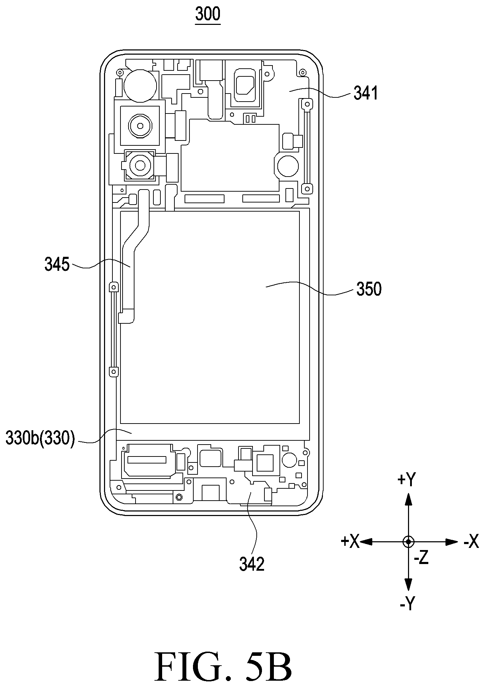

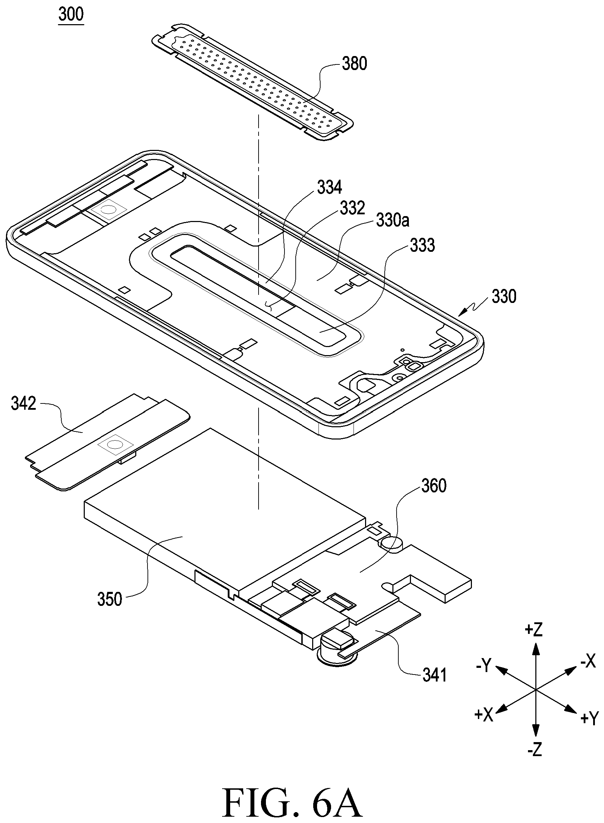

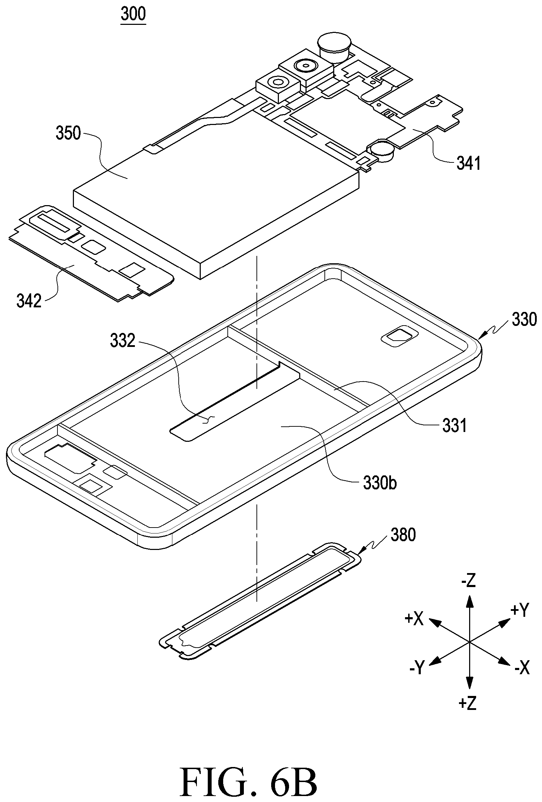

FIG. 5A is a front view of an electronic device according to various embodiments of the disclosure. FIG. 5B is a rear view of an electronic device according to various embodiments of the disclosure. FIG. 6A is a front perspective view illustrating the exploded state of an electronic device and a heat-radiating member according to various embodiments of the disclosure. FIG. 6B is a rear perspective view illustrating the exploded state of an electronic device and a heat-radiating member according to various embodiments of the disclosure.

Referring to FIGS. 5A to 6B, an electronic device 300 (e.g., the electronic device 200 in FIGS. 2 to 4) may include a support member 330, a heat-radiating member 380, printed circuit boards 341, 342, and 345, a battery 350, and a heat source 360.

Some or all of the configurations of the support member 330, the printed circuit boards 341, 342, and 345, and the battery 350 in FIGS. 5A to 6B may be the same as those of the support member 232, the printed circuit board 240, and the battery 250 in FIG. 4.

According to various embodiments, the support member 330 may include a first surface 330a facing a display (not shown) (e.g., the display 220 in FIG. 4) and a second surface 330b facing in the opposite direction of the first surface 330a.

According to an embodiment, the first surface 330a may be configured to support at least a portion of the display or to accommodate at least a portion of the display. According to an embodiment, the second surface 330b may face the opposite direction (e.g., the -Z-axis direction in FIG. 4) of the first surface 330a, and at least a portion of the second surface 330b may be configured to support at least a portion of the battery 350 or accommodate at least a portion of the battery 350.

According to an embodiment, the support member 330 may further include a first opening 332 formed to penetrate at least a portion of the first surface 330a and the second surface 330b. According to an embodiment, at least a portion of the heat-radiating member 380 may be disposed or accommodated in the first opening 332.

According to an embodiment, the support member 330 may further include a groove-shaped seating portion 333 that is disposed adjacent to the first opening 332 and formed to be stepped from the first surface 330a. The seating portion 333 may be configured such that a portion of the heat-radiating member 380 is seated thereon or may be configured to support the portion of the heat-radiating member 380.

In an embodiment, the heat-radiating member 380 may be disposed on a stepped portion 334 of the support member 330, which is formed such that at least a portion of the edge is stepped from the first surface 330a. For example, the heat-radiating member 380 may be coupled to the stepped portion 334 of the support member 330 by laser welding.

According to various embodiments, the battery 350 may be disposed on the second surface 330b of the support member 330 such that at least a portion thereof faces the first opening 332.

According to various embodiments, the printed circuit boards 341, 342, and 345 may include a first printed circuit board 341, a second printed circuit board 342, and a third printed circuit board 345.

According to an embodiment, the first printed circuit board 341 may be disposed on at least a portion of the second surface 330b of the support member 330 so as to be spaced apart from the battery 350. For example, the first printed circuit board 341 may be defined and interpreted as a main circuit board, and may be disposed adjacent to one side of the battery 350 (e.g., a portion facing the +Y-axis direction in FIG. 6A).

According to an embodiment, the second printed circuit board 342 may be disposed on the second surface 330b of the support member 330 so as to be spaced apart from the battery 350. For example, the second printed circuit board 342 may be defined and interpreted as a sub-circuit board, and may be disposed adjacent to the other side of the battery 350 (e.g., the portion facing the -Y-axis direction in FIG. 6A).

According to an embodiment, the third printed circuit board 345 may electrically connect the first printed circuit board 341 and a key input device (not shown) (e.g., the key input device 217 in FIG. 2). For example, the third printed circuit board 345 may include a flexible printed circuit board (PCB).

According to an embodiment, at least one heat source 360 may be disposed on the first printed circuit board 341. For example, at least one heat source 360 may be disposed and/or mounted on one side (e.g., the side facing the +Z-axis direction in FIG. 6A) of the first printed circuit board 341. In an embodiment, the heat source 360 may include a processor (e.g., the processor 120 in FIG. 1).

According to various embodiments, the heat-radiating member 380 may be disposed on the first surface 330a of the support member 330. According to an embodiment, at least a portion of the heat-radiating member 380 may be disposed in the first opening 332.

According to an embodiment, at least a portion of the heat-radiating member 380 may be disposed or accommodated in the first opening 332, and a portion, which is different from the at least a portion may be disposed on the seating portion 333.

According to various embodiments, the heat-radiating member 380 may be configured to mediate heat transfer between a display (e.g., the display 220 in FIG. 4) and the first printed circuit board 341. For example, the heat generated from the display (e.g., the display 220 in FIG. 4) may be transferred to the first printed circuit board 341 through the heat-radiating member 380, or the heat generated from the first printed circuit board 341 may be transferred to the display (e.g., the display 220 in FIG. 4) through the heat-radiating member 380.

According to an embodiment, the heat-radiating member 380 may be configured to transfer heat generated from at least one heat source 360 to the display (e.g., the display 220 in FIG. 4). According to an embodiment, the heat-radiating member 380 may include at least one of a vapor chamber, a heat pipe, a heat sink, a heat spreader, a copper (Cu) plate, and/or a graphite sheet.

According to an embodiment, the second surface 330b of the support member 330 may further include a partition wall 331 configured to spatially partition at least one of the at least one heat source 360 or the first printed circuit board 341 from the battery 350.

According to an embodiment, since the heat generated from at least one heat source 360 is dissipated or transmitted through the heat-radiating member 380, it is possible to prevent excessive heat from accumulating in at least one heat source 360.

For example, heat generated from at least one heat source 360 may be dissipated or transmitted to the display (e.g., the display 220 in FIG. 4), the support member 330, or another structure (e.g., the rear case 260 in FIG. 4) that is directly or indirectly coupled or connected to the support member 330 through the heat-radiating member 380.

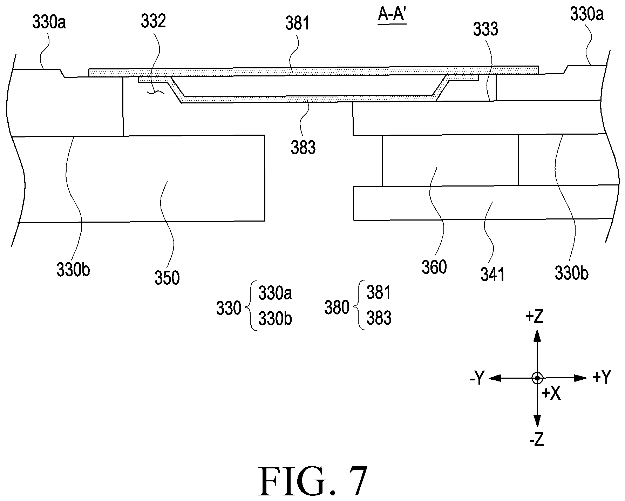

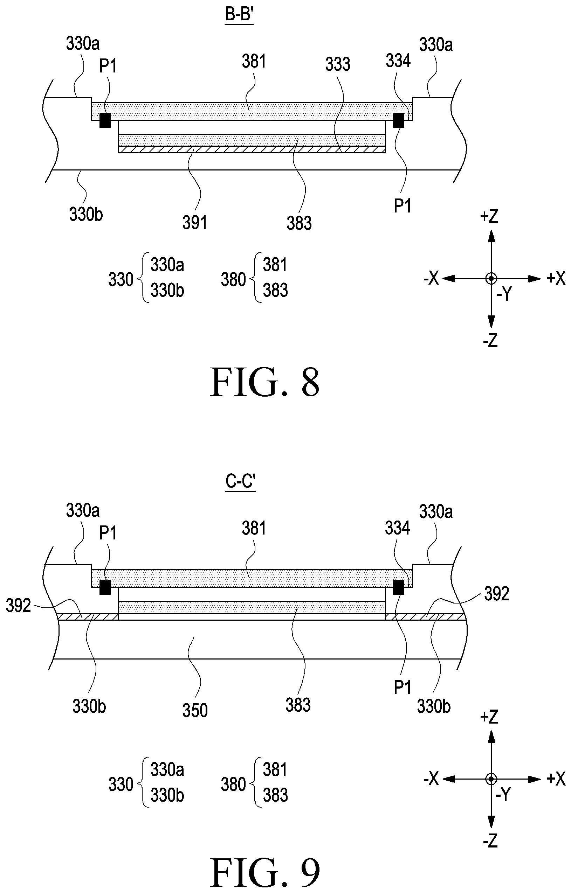

FIG. 7 is a cross-sectional view taken along line A-A' in FIG. 5A according to various embodiments of the disclosure. FIG. 8 is a cross-sectional view taken along line B-B' in FIG. 5A according to various embodiments of the disclosure. FIG. 9 is a cross-sectional view taken along line C-C' in FIG. 5A according to various embodiments of the disclosure.

Referring to FIGS. 7 to 9, an electronic device (e.g., the electronic device 300 in FIGS. 5A to 6B) may include a support member 330, a battery 350, at least one heat source 360, and a first printed circuit board 341, and a heat-radiating member 380.

Some or all of the configurations of the support member 330, the battery 350, at least one heat source 360, the first printed circuit board 341, and the heat-radiating member 380 in FIGS. 7 to 9 may be the same as those of the configurations of the support member 330, the battery 350, at least one heat source 360, the first printed circuit board 341, and the heat-radiating member 380 in FIGS. 5A to 6B.

According to various embodiments, the heat-radiating member 380 may include a first area 381 having at least a portion disposed to overlap the first surface 330a and a second area 383 coupled to the first area 381 and having at least a portion disposed in the first opening 332. According to an embodiment, at least a portion of the first area 381 may be coupled to the support member 330 by laser welding.

According to various embodiments, at least a portion of the second area 383 may be disposed in the first opening 332. According to an embodiment, the second area 383 may include a first portion coupled to the first area 381 and a second portion connected to the first portion and spaced apart from the first area 381. According to an embodiment, the second portion may have at least a portion spaced apart from at least a portion of the battery 350, and the remaining portion in contact with at least a portion of the seating portion 333.

According to an embodiment, at least one heat source 360 may be disposed such that at least a portion thereof faces at least a portion (e.g., the second portion) of the second area 383 with the support member 330 therebetween. For example, at least one heat source 360 may come into contact with at least a portion of the second surface 330b of the support member 330. Heat generated from at least one heat source 360 may be transmitted to the display (e.g., the display 220 in FIG. 4) through at least a portion of the support member 330 and the heat-radiating member 380 (e.g., the first area 381 and/or the second area 383). For example, at least a portion of the first area 381 may be connected to or in contact with at least a portion of the display (e.g., the display 220 in FIG. 4). Heat generated from at least one heat source 360 may be dissipated or dispersed to the support member 330 through at least a portion of the support member 330. Heat generated from at least one heat source 360 may be dissipated or transferred to another structure (e.g., the rear case 260 in FIG. 4) directly or indirectly connected to the support member 330 through at least a portion of the support member 330 and/or the heat-radiating member 380.

According to an embodiment, at least a portion of the edges of the first area 381 may be coupled to the support member 330 by laser welding P1. For example, the first area 381 may have at least a portion of both edges in width direction of the first area 381 (e.g., the X-axis direction in FIGS. 7 to 9) may be coupled to the first surface 330a of the support member 330 by laser welding. In an embodiment, at least a portion of the edges of the first area 381 may be coupled to a stepped portion 334 formed to be stepped from the first surface 330a by laser welding. In another embodiment, at least a portion of the edges of the first area 381 may be bonded and/or coupled to the stepped portion 334 formed to be stepped from the first surface 330a through an adhesive member (e.g., tapes).

According to various embodiments, the support member 330 and the heat-radiating member 380 may be made of the same material or may be made of different materials from each other. According to an embodiment, the support member 330 may include metal materials (e.g., aluminum (Al), magnesium (Mg), or stainless steel (SUS)) and/or non-metal materials (e.g., polycarbonate (PC)). According to an embodiment, the heat-radiating member 380 may include a heat pipe or vapor chamber made of a metal material (e.g., stainless steel (SUS), copper (Cu), aluminum (Al), or titanium (Ti)).

Referring to FIG. 8, the electronic device (e.g., the electronic device 300 in FIGS. 5A to 6B) may further include a first adhesive member 391 that bonds at least a portion of the second area 383 to the seating portion 333.

Referring to FIG. 9, the electronic device (e.g., the electronic device 300 in FIGS. 5A to 6B) may further include a second adhesive member 392 that bonds at least a portion of the battery 350 to at least a portion of the second surface 330b of the support member 330.

In an embodiment, the battery 350 may be spaced apart from at least a portion (e.g., the second area 383) of the heat-radiating member 380. For example, a predetermined space may be formed between the battery 350 and the second area 383 of the heat-radiating member 380.

Referring to FIG. 9, according to a certain embodiment, the support member 330 may be produced by injection molding so as to include a metal material (e.g., stainless steel (SUS)) and a non-metal material (e.g., polycarbonate (PC)). According to a certain embodiment, the stepped portion 334 of the support member 330 may be made of a non-metal material. According to a certain embodiment, the first area 381 of the heat-radiating member 380 may be laser-bonded to the stepped portion 334 of the support member 330 by laser heat (P1). According to a certain embodiment, the first area 381 may be coupled to the stepped portion 334 of the support member 330 while being seated on the stepped portion 334 by heat of a laser radiated onto the second surface 330b of the support member 330. According to a certain embodiment, since the stepped portion 334 and the first area 381 are coupled by laser heat, burrs may be prevented from occurring.

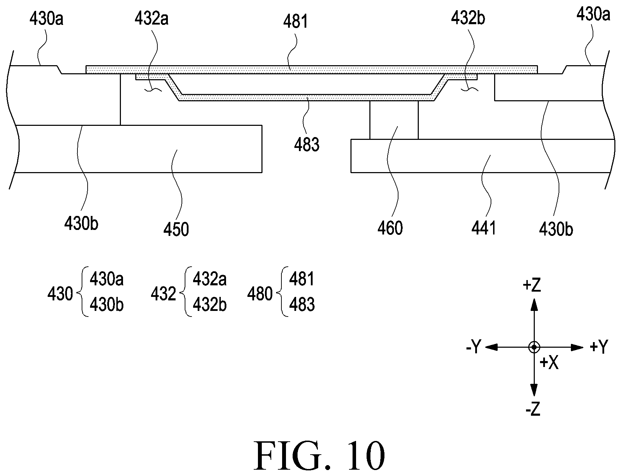

FIG. 10 is a cross-sectional view illustrating an electronic device and a heat-radiating member according to various embodiments of the disclosure.

Referring to FIG. 10, an electronic device (e.g., the electronic device 300 in FIGS. 5A to 6B) may include a support member 430 including a first surface 430a and a second surface 430b, a battery 450, at least one heat source 460, a first printed circuit board 441, and a heat-radiating member 480.

Some or all of the configurations of the support member 430 including the first surface 430a and the second surface 430b, the battery 450, at least one heat source 460, the first printed circuit board 441, and the heat-radiating member 480 in FIG. 10 may be the same as those of the support member 330 including the first surface 330a and the second surface 330b, the battery 350, at least one heat source 360, the first printed circuit board 341, and the heat-radiating member 380 in FIGS. 7 to 9.

According to various embodiments, the heat-radiating member 480 may include a first area 481 having at least a portion disposed to overlap the first surface 430a and a second area 483 coupled to the first area 481 and having at least a portion disposed in the first opening 432. According to an embodiment, at least a portion of the first area 481 may be coupled to the support member 430 by laser welding.

According to various embodiments, the first opening 432 may include a (1-1)th opening 432a disposed to face the battery 450 and a (1-2)th opening 432b extending from the (1-1)th opening 432a and disposed to face the first printed circuit board 441 or at least one heat source 460.

According to various embodiments, at least a portion of the second area 483 may be disposed in the first opening 432. According to an embodiment, at least a portion of the second area 483 may be disposed in the (1-1)th opening 432a, and a portion, which is different from the at least a portion, may be disposed in the (1-2)th opening 432b.

According to an embodiment, the second area 483 may include a first portion coupled to the first area 481 and a second portion connected to the first portion and spaced apart from the first area 481. According to an embodiment, the second portion may have at least a portion spaced apart from at least a portion of the battery 450, and the remaining portion in contact with at least a portion of at least one heat source 460.

According to an embodiment, at least a portion of at least one heat source 460 may be in contact with at least a portion of the second area 483. Heat generated from at least one heat source 460 may be configured to be transferred to the display (e.g., the display 202 in FIG. 4) through the second area 483 and the first area 481.

According to an embodiment, heat generated from at least one heat source 460 may be dissipated, transferred, or dispersed to the display (e.g., the display 220 in FIG. 4), the support member 430, or another structure (e.g., the rear case 260 in FIG. 4) directly or indirectly connected to the support member 430 through the heat-radiating member 480.

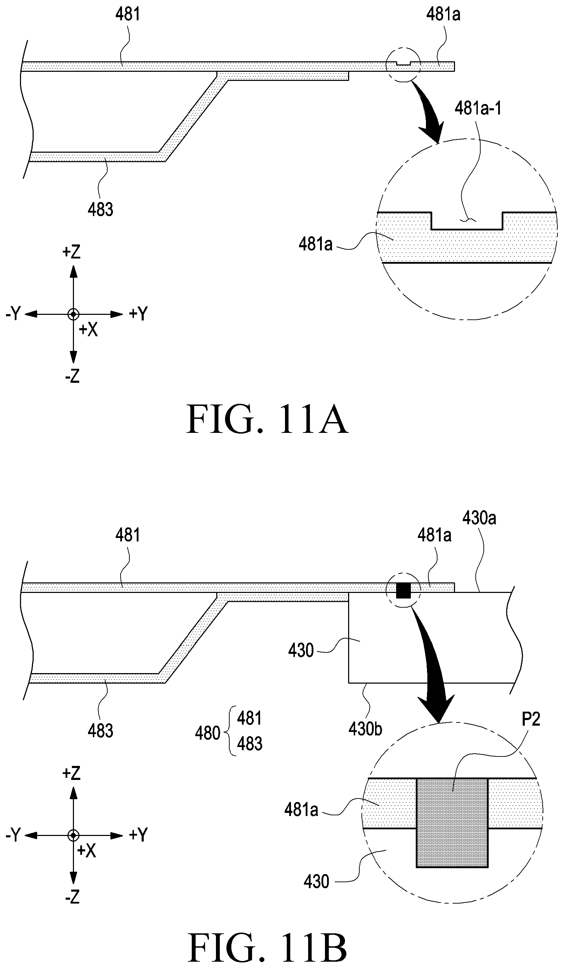

FIG. 11A is a diagram illustrating a state before a heat-radiating member is laser-welded according to various embodiments of the disclosure. FIG. 11B is a diagram illustrating a state after a heat-radiating member is laser-welded according to various embodiments of the disclosure.

Referring to FIGS. 11A to 11B, an electronic device (e.g., the electronic device 300 in FIGS. 5A to 6B) may include a heat-radiating member 480 and a support member 430.

Some or all of the configurations of the heat-radiating member 480 and the support member 430 in FIGS. 11A to 11B may be the same as those of the heat-radiating member 480 and the support member 430 in FIG. 10.

According to various embodiments, the first area 481 may include a (1-1)th area 481a seated on at least a portion of the first surface 430a of the support member 430.

Referring to FIG. 11A, it may include a (1-1)th recess 481a-1 recessed in at least a portion of the (1-1)th area 481a. According to an embodiment, the (1-1)th recess 481a-1 may be spaced apart from one end (e.g., the end directed in the +Y-axis direction in FIG. 11A) of the (1-1)th area 481a and formed to be recessed from the upper surface (e.g., the surface facing the +Z-axis direction in FIG. 11a) of the (1-1)th area 481a to the lower surface (e.g., the surface facing the -Z-axis direction in FIG. 11a) of the (1-1)th area 481a.

Referring to FIG. 11B, at least a portion of the (1-1)th area 481a may be coupled to at least a portion of the first surface 430a by laser welding P2. The laser welding P2 may be performed on the (1-1)th recess (e.g., the (1-1)th recess 481a-1 in FIG. 11A) of the (1-1)th area 481a. For example, even if at least a portion of the (1-1)th area 481a and the support member 430 is melted by laser welding P2 to produce burrs, the produced burrs may be accommodated in the (1-1)th recess 481a-1 by the depth thereof. Accordingly, the upper surface of the (1-1)th area 481a-1 may not produce protruding portions even after laser welding P2 is performed.

Referring to FIGS. 11A to 11B, side surfaces (e.g., a side surface directed in the -X-axis direction in FIG. 6A and a side surface directed in the +X-axis direction in FIG. 6A) of the (1-1)th area 481a may be coupled to the first surface 430a of the support member 430 by laser welding P2. When performing laser welding P2 on the first surface 430a of the (1-1)th area 481a, the laser beam may move repeatedly in the first direction (e.g., the Y-axis direction in FIGS. 11A to 11B) or in the second direction (e.g., the X-axis direction in FIGS. 11A to 11B) in proportion to the specified welding speed and frequency, so that the side surface of the (1-1)th area 481a may be coupled to the first surface 430a. At this time, the side surface of the (1-1)th area 481a may melt, flow down to the first surface 430a of the support member 430, and solidify into a fillet shape, thereby forming a welded portion. According to a certain embodiment, the laser beam for laser welding P2 may move in at least one of a spiral pattern, a sinusoidal pattern, an infinity symbol pattern, or a linear pattern, but is not limited thereto, and may have various movement patterns.

According to a certain embodiment, side surfaces (e.g., a side surface directed in the +Y-axis direction in FIG. 6A and a side surface directed in the -Y-axis direction in FIG. 6B) of the first area 481 may be coupled to the first surface 430a of the support member 430 by laser welding P2.

According to a certain embodiment, portions (e.g., a portion facing the +X-axis direction in FIG. 6A and a portion facing the -X-axis direction in FIG. 6A) of the first area 481, which overlap the stepped portion (e.g., the stepped portion 334 in FIG. 6A) of the support member 430, may be coupled to the stepped portion by laser welding P2.

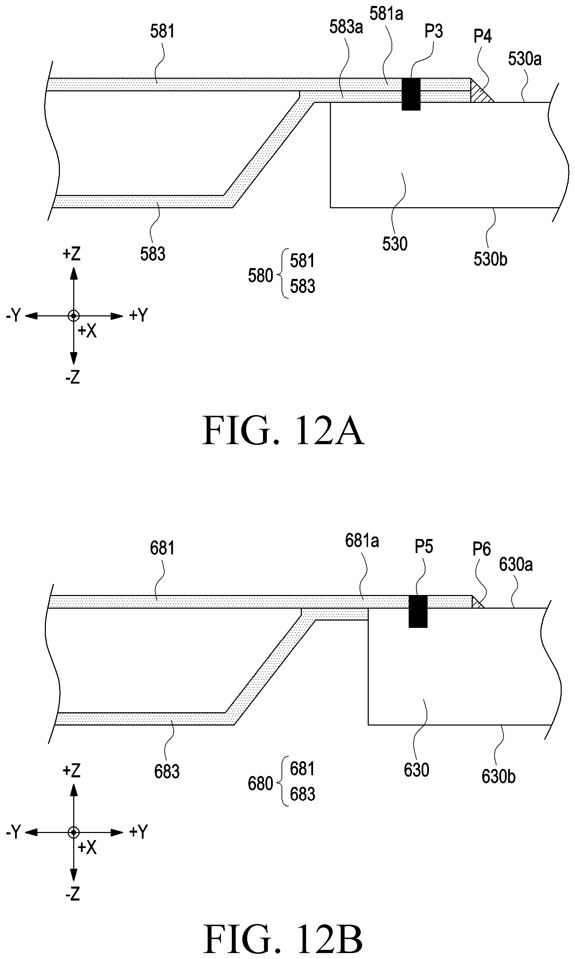

FIG. 12A is a diagram illustrating a state after a heat-radiating member is laser-welded according to various embodiments of the disclosure.

Referring to FIG. 12A, an electronic device (e.g., the electronic device 300 in FIGS. 5A to 6B) may include a heat-radiating member 580 and a support member 530.

Some or all of the configurations of the heat-radiating member 580 and the support member 530 in FIG. 12A may be the same as those of the heat-radiating member 480 and the support member 430 in FIG. 10.

According to various embodiments, the first area 581 may include a (1-1)th area 581a seated on at least a portion of a first surface 530a of the support member 530.

According to various embodiments, the second area 583 may include a (2-1)th area 583a disposed between the (1-1)th area 581a and at least a portion of the first surface 530a.

Referring to FIG. 12A, at least a portion of the (2-1)th area 583a may be coupled to at least a portion of the (1-1)th area 581a and the first surface 530a by laser welding P3 or P4.

According to an embodiment, at least a portion (e.g., the end directed in the +Y-axis direction in FIG. 12A) of the edges of the (2-1)th area 583a may be coupled to at least a portion of the edges of the (1-1)th area 581a and at least a portion of the first surface 530a by laser welding P4.

According to an embodiment, the portion spaced apart from the edge of the (2-1)th area 583a may be coupled to at least a portion of the (1-1)th area 581a and the first surface 530a by laser welding P3.

According to an embodiment, at least a portion of the (1-1)th area 581a and at least a portion of the (2-1)th area 583a are laser-welded P3 while overlapping each other, thereby securing sufficient size, area, or thickness of the welded portion. In addition, since the size, area, or thickness of the welded portion is sufficiently secured, the bonding force between the heat-radiating member 580 and the support member 530 may be sufficiently obtained. Accordingly, since the sufficient bonding force is secured, the area or size of the portion (e.g., the (1-1)th area 581a and the (2-1)th area 583a) of the heat-radiating member 580, which is seated and/or coupled to the support member 530, may be reduced, thereby securing a free space on the first surface 530a of the support member 530. In addition, since the length of the support member 530 (e.g., the length in the Y-axis direction in FIG. 12a) is greater than the length required for coupling with the heat-radiating member 580, the heat capacity may be improved to receive more heat transferred from the heat-radiating member 580.

According to a certain embodiment, portions (e.g., a portion facing the +X-axis direction in FIG. 6A and a portion facing the -X-axis direction in FIG. 6A) of the first area 581, which overlap the stepped portion (e.g., the stepped portion 334 in FIG. 6A) of the support member 530, may be coupled to the stepped portion by laser welding P3 or P4.

FIG. 12B is a diagram illustrating a state after a heat-radiating member is laser-welded according to various embodiments of the disclosure.

Referring to FIG. 12B, an electronic device (e.g., the electronic device 300 in FIGS. 5A to 6B) may include a heat-radiating member 680 and a support member 630.

Some or all of the configurations of the heat-radiating member 680 and the support member 630 in FIG. 12B may be the same as those of the heat-radiating member 480 and the support member 430 in FIG. 10.

According to various embodiments, the first area 681 may include a (1-1)th area 681a seated on at least a portion of the first surface 630a of the support member 630.

According to an embodiment, at least a portion (e.g., the end directed in the +Y-axis direction in FIG. 12B) of the edges of the (1-1)th area 683a may be coupled to at least a portion of the first surface 630a by laser welding P6.

According to an embodiment, the portion of the (1-1)th area 683a, which is spaced apart from the edge, may be coupled to at least a portion of the first surface 630a by laser welding P5.

According to an embodiment, the (1-1)th area 681a may be coupled to the first surface 630a, and the second area 683 may not be coupled to the first surface 630a. The support member 630 may increase its thickness by the thickness (e.g., the thickness in the Z-axis direction in FIG. 12B) of at least a portion (e.g., a portion of the second area 683 coupled to the first area 681) of the second area 683. As the thickness of the support member 630 increases, the rigidity of the support member 630 may be improved. According to a certain embodiment, portions (e.g., a portion facing the +X-axis direction in FIG. 6A and a portion facing the -X-axis direction in FIG. 6A) of the first area 681, which overlap the stepped portion (e.g., the stepped portion 334 in FIG. 6A) of the support member 630, may be coupled to the stepped portion by laser welding P5 or P6.

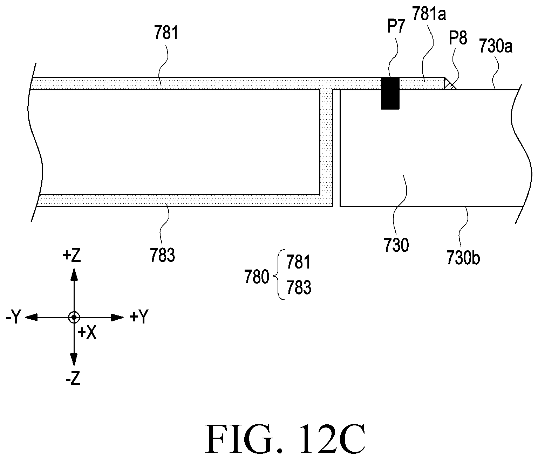

FIG. 12C is a diagram illustrating a state after a heat-radiating member is laser-welded according to various embodiments of the disclosure.

Referring to FIG. 12C, an electronic device (e.g., the electronic device 300 in FIGS. 5A to 6B) may include a heat-radiating member 780 and a support member 730.

Some or all of the configurations of the heat-radiating member 780 and the support member 730 in FIG. 12C may be the same as those of the heat-radiating member 480 and the support member 430 in FIG. 10.

According to various embodiments, the first area 781 may include a (1-1)th area 781a seated on at least a portion of the first surface 730a of the support member 730.

According to an embodiment, at least a portion (e.g., the end directed in the +Y-axis direction in FIG. 12C) of the edges of the (1-1)th area 783a may be coupled to at least a portion of the first surface 730a by laser welding P8.

According to an embodiment, the portion of the (1-1)th area 783a, which is spaced apart from the edge, may be coupled to at least a portion of the first surface 730a by laser welding P7.

According to an embodiment, at least a portion of the second area 783 may be disposed substantially perpendicular to the first area 781a.

According to an embodiment, the (1-1)th area 781a may be coupled to the first surface 730a, and the second area 783 may not be coupled to the first surface 730a. At least a portion of the support member 730 may be disposed adjacent to the second area 783. Since the support member 730 may secure the length (e.g., the length in the Y-axis direction in FIG. 12C) up to the portion disposed adjacent to the second area 783, the heat capacity may be improved to receive more heat transferred from the heat-radiating member 780. According to a certain embodiment, portions (e.g., a portion facing the +X-axis direction in FIG. 6A and a portion facing the -X-axis direction in FIG. 6A) of the first area 781, which overlap the stepped portion (e.g., the stepped portion 334 in FIG. 6A) of the support member 730, may be coupled to the stepped portion by laser welding P7 or P8.

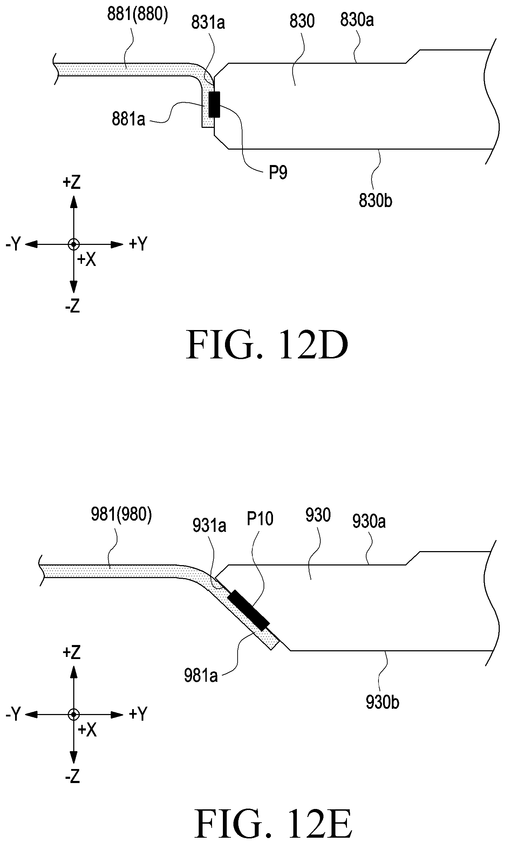

FIG. 12D is a diagram illustrating a state after a heat-radiating member is laser-welded according to various embodiments of the disclosure.

Some or all of the configurations of the heat-radiating member 880 and the support member 830 in FIG. 12D may be the same as those of the heat-radiating member 480 and the support member 430 in FIG. 10.

According to various embodiments, the first area 881 may include a (1-1)th area 881a seated on at least a portion of the support member 830. According to an embodiment, the (1-1)th area 881a may be disposed substantially perpendicular to the remaining portion of the first area 881.

According to an embodiment, the (1-1)th area 881a may be coupled to at least a portion of the inner side surface 831a of the support member 830 surrounding the first opening (e.g., the first opening 332 in FIG. 7) by laser welding P9.

According to an embodiment, since the heat-radiating member 880 is coupled to the inner side surface 831a of the support member 830, the combined structure of the heat-radiating member 880 and the support member 830 may result in a compact structure that does not increase the thickness (e.g., the thickness in the Z-axis direction in FIG. 12D).

According to a certain embodiment, the first area 881 may be coupled to at least a portion of the inner side surface forming the first opening (e.g., the first opening 332 in FIG. 6A) of the support member 830 (e.g., the inner side surface of the support member 330 surrounding the portion of the first opening 332 directed in the -X-axis direction in FIG. 6A and the inner side surface of the support member 330 surrounding the portion of the first opening 332 directed in the +X-axis direction in FIG. 6A) by laser welding P9. According to a certain embodiment, a portion of the first area 881, which faces the inner side surface (e.g., the inner side surface of the support member 330 surrounding the portion of the first opening 332 directed in the -X-axis direction in FIG. 6A and the inner side surface of the support member 330 surrounding the portion of the first opening 332 directed in the +X-axis direction in FIG. 6A), may be disposed substantially perpendicular to the remaining portion.

FIG. 12E is a diagram illustrating a state after a heat-radiating member is laser-welded according to various embodiments of the disclosure.

Some or all of the configurations of the heat-radiating member 980 and the support member 930 in FIG. 12E may be the same as those of the heat-radiating member 480 and the support member 430 in FIG. 10.

According to various embodiments, the first area 981 may include a (1-1)th area 981a seated on at least a portion of the support member 930. According to an embodiment, the (1-1)th area 981a may be disposed at an angle with respect to the remaining portion of the first area 981.

According to an embodiment, the (1-1)th area 981a may be coupled to at least a portion of the inner side surface 931a of the support member 930 surrounding the first opening (e.g., the first opening 332 in FIG. 7) by laser welding P10.

According to an embodiment, since the heat-radiating member 980 is coupled to the inner side surface 931a of the support member 930, the combined structure of the heat-radiating member 980 and the support member 930 may result in a compact structure that does not increase the thickness (e.g., the thickness in the Z-axis direction in FIG. 12D).

According to a certain embodiment, the first area 981 may be coupled to at least a portion of the inner side surface forming the first opening (e.g., the first opening 332 in FIG. 6A) of the support member 930 (e.g., the inner side surface of the support member 330 surrounding the portion of the first opening 332 directed in the -X-axis direction in FIG. 6A and the inner side surface of the support member 330 surrounding the portion of the first opening 332 directed in the +X-axis direction in FIG. 6A) by laser welding P10. According to a certain embodiment, a portion of the first area 981, which faces the inner side surface (e.g., the inner side surface of the support member 330 surrounding the portion of the first opening 332 directed in the -X-axis direction in FIG. 6A and the inner side surface of the support member 330 surrounding the portion of the first opening 332 directed in the +X-axis direction in FIG. 6A), may be disposed substantially inclined with respect to the remaining portion.

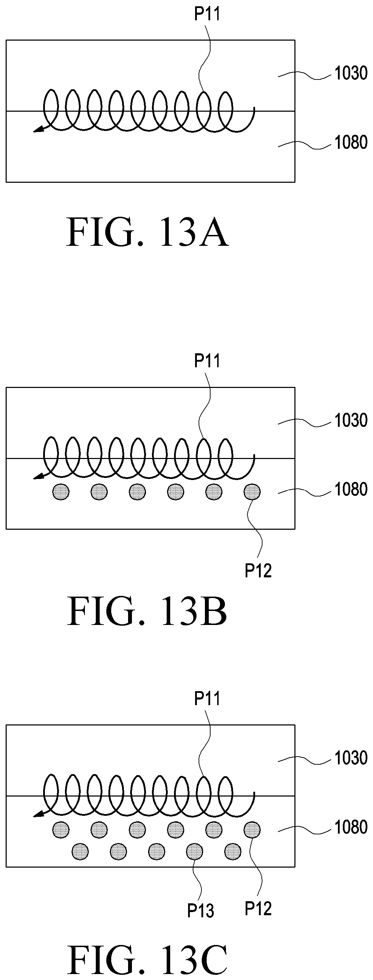

FIG. 13A is a conceptual diagram illustrating wobble laser welding according to various embodiments of the disclosure. FIG. 13B is a conceptual diagram illustrating wobble laser welding and spot laser welding according to various embodiments of the disclosure. FIG. 13C is a conceptual diagram illustrating wobble laser welding and spot laser welding according to various embodiments of the disclosure.

Some or all of the configuration of the heat-radiating member 1080 and the support member 1030 in FIGS. 13A to 13C may be the same as those of the heat-radiating member 480 and the support member 430 in FIG. 10.

Examples of laser welding P11 to P13 to be described in FIGS. 13A to 13C may be applied to the laser welding P1 to P10 in FIGS. 8 to 12E described above.

Referring to FIG. 13A, laser welding P11 to P13 may include at least one of wobble laser welding P11 and spot laser welding P12 and P13.

According to an embodiment, the wobble laser welding P11 may be performed on the interface between the heat-radiating member 1080 and the support member 1030. In an embodiment, the wobble laser welding P11 may include various rotation patterns (e.g., the spiral pattern, the sinusoidal pattern, the infinity pattern, or the linear pattern). According to an embodiment, the wobble laser welding P11 may melt and join the interface surfaces of the heat-radiating member 1080 and the support member 1030 that face each other.

According to an embodiment, the spot laser welding P12 and P13 may be performed to be adjacent to the wobble laser welding P11 to supplement the bonding force caused by the wobble laser welding P11. According to an embodiment, at least one spot laser welding P12 or P13 may be performed on at least one point of the heat-radiating member 1080, and the heat-radiating member 1080 and the support member 1030 (e.g., the stepped portion 334 in FIG. 8) overlapping at the point may be melted and bonded.

According to an embodiment, the spot laser welding P12 and P13 may include at least one first spot laser welding P12 disposed adjacent to the wobble laser welding P11 and at least one second spot laser welding P13 disposed substantially in parallel to the first spot laser welding P12.

According to a certain embodiment (not shown), the spot laser welding P12 and P13, not limited to two rows, may be arranged in one row or in three or more rows. According to a certain embodiment (not shown), the wobble laser welding P11 may be performed multiple times and arranged in multiple rows. According to a certain embodiment (not shown), the spot laser welding P12 and P13 may be formed into spots of various shapes in addition to circular spots. According to a certain embodiment (not shown), the first spot laser welding P12 may have N spots per unit length, and the second spot laser welding P13 may have M spots per unit length, which is different from the N spots.

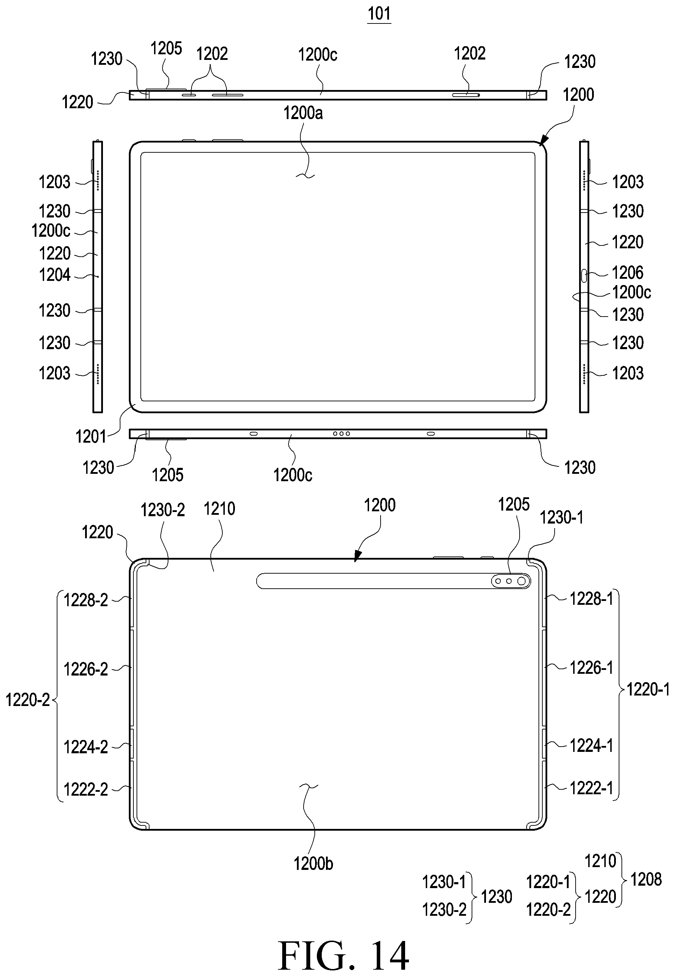

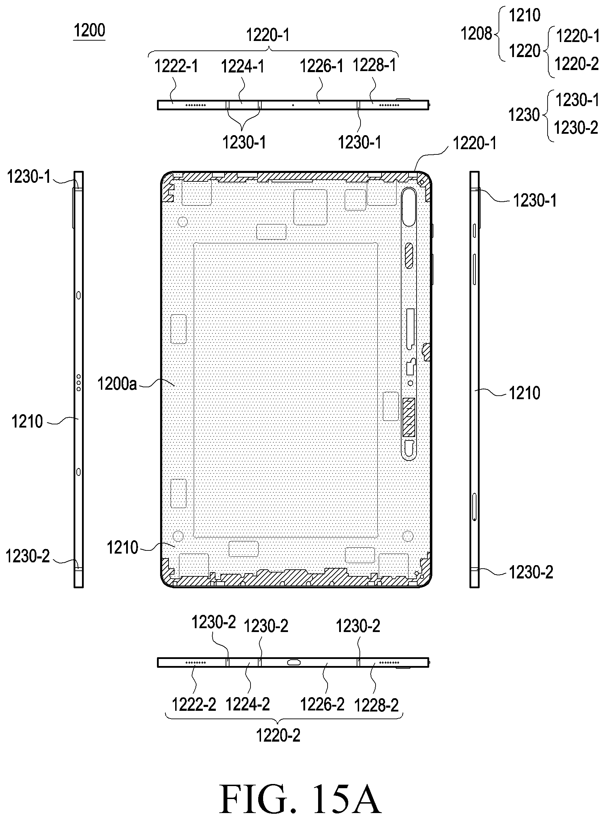

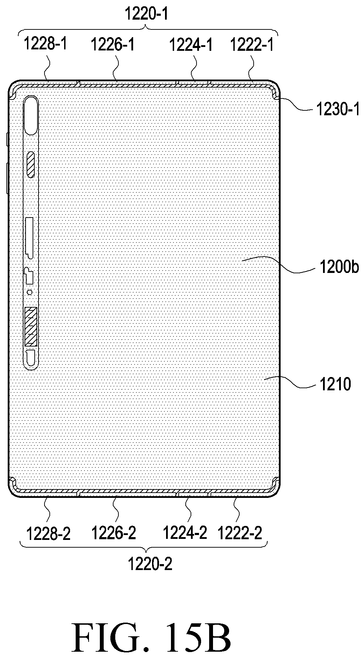

FIG. 14 is a plan view of an electronic device according to various embodiments of the disclosure. FIG. 15A is a plan view of a housing according to various embodiments of the disclosure. FIG. 15B is a plan view of a housing according to various embodiments of the disclosure.

Referring to FIGS. 14 to 15B, the electronic device 101 may be an electronic device (e.g., a tablet). The electronic device 101 may include a housing 1200 including metal areas 1208 and resin areas 1230.

According to various embodiments, the housing 1200 may include a front surface 1200a, a rear surface 1200b, and a side surface 1200c surrounding the space between the front surface 1200a and the rear surface 1200b. According to an embodiment, the front surface 1200a may be a front plate that is at least partially transparent. For example, the front surface 1200a of the housing 1200 may include a glass plate or a polymer plate including various coating layers. According to an embodiment, the rear surface 1200b and/or the side surface 1200c may be formed of metal. According to an embodiment, the front surface 1200a, the rear surface 1200b, and/or the side surface 1200c of the housing 1200 may be interpreted as the front surface 1200a, the rear surface 1200b, and/or the side surface 1200c of the electronic device 101.

According to various embodiments, the metal areas 1208 may include a first metal area 1210 and a second metal area 1220. According to an embodiment, the metal areas 1208 may include at least one of aluminum, stainless steel, or magnesium. According to an embodiment, the second metal area 1220 may be spaced apart from the first metal area 1210.

According to various embodiments, the first metal area 1210 may support the components (e.g., a battery (the battery 189 in FIG. 1) and a display module (the display module 160 in FIG. 1)) of the electronic device 101. According to an embodiment, the first metal area 1210 may form at least a portion of the edges of the electronic device 101. For example, the first metal area 1210 may form at least a portion of the rear surface 1200b and the side surface 1200c.

According to various embodiments, the second metal area 1220 may perform an antenna function. For example, the second metal area 1220 may be electrically connected to an antenna module (e.g., the antenna module 197 in FIG. 1) to transmit or receive electromagnetic waves.

According to various embodiments, the second metal area 1220 may form at least a portion of the edges of the electronic device 101. For example, the second metal area 1220 may form at least a portion of the side surface 1200c of the housing 1200.

According to various embodiments, a plurality of second metal areas 1220 may be formed. According to an embodiment, the second metal areas 1220 may be located at the front and rear of the housing 1200. For example, the second metal areas 1220 may include a front second metal area 1220-1 located at the front of the housing 1200 and a rear second metal area 1220-2 spaced apart from the front second metal area 1220-1.

According to various embodiments, the second metal area 1220 may include a plurality of second metal areas segmented by the resin areas 1230. For example, the front second metal area 1220-1 and the rear second metal area 1220-2 of the second metal areas 1220 may be separated into a plurality of antennas to perform an antenna function. According to an embodiment, the front second metal area 1220-1 may include at least one of a (2-1)th metal area 1222-1, a (2-2)th metal area 1224-1, a (2-3)th metal area 1226-1, or a (2-4)th metal area 1228-1, and the rear second metal area 1220-2 may include at least one of a (2-5)th metal area 1222-2, a (2-6)th metal area 1224-2, a (2-7)th metal area 1226-2, or a (2-8)th metal area 1228-2.

According to various embodiments, the resin area 1230 may connect the first metal area 1210 and the second metal area 1220. According to an embodiment, at least a portion of the resin area 1230 may be disposed between the first metal area 1210 and the second metal area 1220. According to an embodiment, the resin area 1230 may form at least a portion of the rear surface 1200b and/or at least a portion of the side surface 1200c of the housing 1200.

According to various embodiments, a plurality of resin areas 1230 may be provided. According to an embodiment, the resin areas 1230 may be located at the front and rear of the housing 1200. For example, the resin areas 1230 may include a front resin area 1230-1 disposed between the front second metal area 1220-1 and the first metal area 1210, and a rear resin area 1230-2 disposed between the rear second metal area 1220-2 and the first metal area 1210.

According to various embodiments, the electronic device 101 may include a display 1201, a key input structure 1202, audio modules 1203 and 1204, a light-emitting device (not shown), a camera module 1205, and a connector hole 1206, and/or a sensor module (not shown). In a certain embodiment, the electronic device 101 may exclude at least one (e.g., the connector hole 1206) of the elements or may further include other elements.

According to various embodiments, the display 1201 (e.g., the display module 160 in FIG. 1) may be coupled to or adjacent to a touch detection circuit, a pressure sensor capable of measuring the intensity (pressure) of touch, and/or a digitizer that detects a magnetic field-type stylus pen. According to an embodiment, the display 1201 may be visually exposed through the front surface 1200a of the housing 1200.

According to an embodiment, the key input structure 1202 (e.g., the input module 150 or the sensor module 176 in FIG. 1) may be disposed on the side surface 1200c of the housing 1200. In another embodiment, the electronic device 101 may exclude at least part of the above-mentioned key input structure 1202, and the excluded key input structure 1202 may be implemented in other forms such as soft keys on the display 1201.

According to various embodiments, a light-emitting device (not shown) may be disposed, for example, on the front surface 1200a and/or the rear surface 1200b of the housing 1200. For example, the light-emitting device (not shown) may provide status information of the electronic device 101 in the form of light. In another embodiment, the light-emitting device (not shown) may provide a light source that is linked to the operation of, for example, a front camera module (not shown) or a rear camera module 1205. The light-emitting device (not shown) may include, for example, LEDs, IR LEDs, and/or xenon lamps.

According to various embodiments, the camera module 1205 (e.g., the camera module 180 in FIG. 1) may include one or more lenses, an image sensor, an image signal processor, and/or a flash. The flash may include, for example, a light-emitting diode or a xenon lamp. In a certain embodiment, two or more lenses (an infrared camera, a wide-angle lens, and a telephoto lens) and image sensors may be disposed on one side of the electronic device 101. According to an embodiment, the electronic device 101 may include a front camera module (not shown) (e.g., an under-display camera (UDC)) disposed on the front surface 1200a of the electronic device 101 and a rear camera module 1205 disposed on the rear surface 1200b of the electronic device 101.

According to various embodiments, the connector hole 1206 (e.g., the connection terminal 178 in FIG. 1) may receive, for example, a connector (e.g., a USB connector) for transmitting and receiving power and/or data to and from an external electronic device and a connector (e.g., an earphone jack) for transmitting and receiving an audio signal to and from an external electronic device.

According to an embodiment of various embodiments, the sensor module (e.g., the sensor module 176 in FIG. 1) may generate an electrical signal or data value corresponding to an internal operation state of the electronic device 101 or an external environmental state. The sensor module (not shown) may include, for example, a first sensor module (not shown) (e.g., a proximity sensor) and/or a second sensor module (not shown) (e.g., a fingerprint sensor) disposed on the front surface 1200a of the housing 1200, and/or a third sensor module (not shown) (e.g., an HRM sensor) and/or a fourth sensor module (not shown) (e.g., a fingerprint sensor) disposed on the rear surface 1200b of the housing 1200. In a certain embodiment (not shown), the fingerprint sensor may be disposed on the rear surface 1200b, as well as the front surface 1200a (e.g., the display 1201) of the housing 1200. The electronic device 101 may further include a sensor module that is not shown, for example, at least one of a gesture sensor, a gyro sensor, an atmosphere pressure sensor, a magnetic sensor, an acceleration sensor, a grip sensor, a color sensor, an infrared (IR) sensor, a biometric sensor, a temperature sensor, a humidity sensor, and an illuminance sensor.

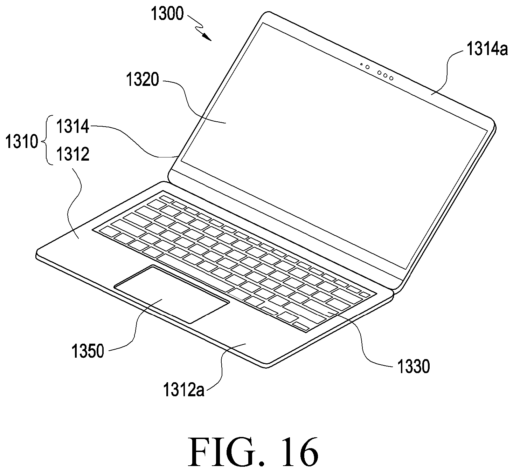

FIG. 16 is a perspective view of an electronic device according to various embodiments of the disclosure.

Referring to FIG. 16, an electronic device 1300 may include a housing 1310, a display 1320, and a touch pad module 1350. According to an embodiment, the electronic device 1300 may be a laptop computer, a notebook computer, or a mobile terminal. Some or all of the configurations of the electronic device 1300 in FIG. 16 may be the same as those of the electronic device 101 in FIG. 1.

According to various embodiments, the housing 1310 may form at least part of the exterior of the electronic device 1300 or support components (e.g., the touch pad module 1350) of the electronic device 1300. For example, the housing 1310 may accommodate at least one of the display 1320, the input device 1330, and the touch pad module 1350.

According to various embodiments, the electronic device 1300 may be open or closed. For example, the housing 1310 may include a first housing 1312 and a second housing 1314 rotatably connected to the first housing 1314. According to an embodiment, the electronic device 1300 may include a hinge module (not shown) connected to the housing 1310. For example, the hinge module (not shown) may be connected to the first housing 1312 and the second housing 1314. According to an embodiment, the first housing 1312 may be configured to rotate at a specified angle (e.g., 0 degrees to about 180 degrees) relative to the second housing 1314. For example, the first front surface 1312a of the first housing 1310 may face at least a portion of the second front surface 1312b of the second housing 1314.

According to various embodiments, the housing 1310 may be formed of a metal material or a non-metal material having a selected level of rigidity. According to an embodiment, at least a portion of the electronic device 1300 made of the metal material may provide a ground plane and may be electrically connected to a ground line formed on a printed circuit board (not shown). For example, the housing 1310 may be electrically connected to the printed circuit board through capacitive components. The housing 1310 may include a heat-radiating module (e.g., the heat-radiating member 380 in FIG. 5A) or a printed circuit board (e.g., the printed circuit boards 341, 342, and 345 in FIG. 5B) inside the housing 1310, and may include a support plate (e.g., the support member 330 in FIGS. 5A and 5B) to strengthen the coupling between the heat-radiating module and the printed circuit board.

According to various embodiments, the display 1320 may be a flexible display in which at least a partial area is able to be transformed into a flat and/or curved surface. For example, the display 1320 may be a foldable or rollable display. Some or all of the configurations of the display 1320 may be the same as those of the display module 160 in FIG. 1. According to an embodiment, at least a portion of the display 1320 may be disposed inside the second housing 1314. For example, at least a portion of the display 1320 may be visually exposed to the outside of the electronic device 1300 through the second housing 1314.

According to various embodiments, the display 1320 may be coupled to or adjacent to a touch detection circuit, a pressure sensor capable of measuring the intensity (pressure) of touch, and/or a digitizer that detects a magnetic field-type stylus pen.

According to various embodiments, the input device 1330 may detect user input (e.g., pressure). According to an embodiment, the input device 1330 may be disposed on the first housing 1312. According to an embodiment, in the state in which the electronic device 1300 is closed, at least a portion of the input device 1330 may face the display 1320. Some or all of the configurations of the input device 1330 in FIG. 16 may be the same as those of the input module 150 in FIG. 1. For example, the input device 1330 may be a keyboard.

According to various embodiments, the touch pad module 1350 may be configured to detect or receive user input. According to an embodiment, the touch pad module 1350 may include a capacitive touch sensor, a touch sensor based on resistive sensing, an optical touch sensor, or a surface acoustic-wave touch sensor. For example, the touch pad module 1350 may detect current, pressure, light, and/or vibration resulting from input applied to the touch pad module 1350 by a user, and a processor (e.g., the processor 120 in FIG. 1) and/or the touch pad module 1350 may determine the user input, based on changes in the detected current, pressure, light, and/or vibration.

According to various embodiments, the touch pad module 1350 may be accommodated in the housing 1310. For example, the touch pad module 1350 may be connected to the first housing 1312, and at least a portion thereof may be exposed to the outside of the first housing 1312. According to an embodiment, the touch pad module 1350 may be adjacent to the input device 1330. According to an embodiment, in the state where the electronic device 1300 is closed, at least a portion of the touch pad module 1350 may face the display 1320. Some or all of the configurations of the touch pad module 1350 may be the same as those of the input module 150 in FIG. 1.

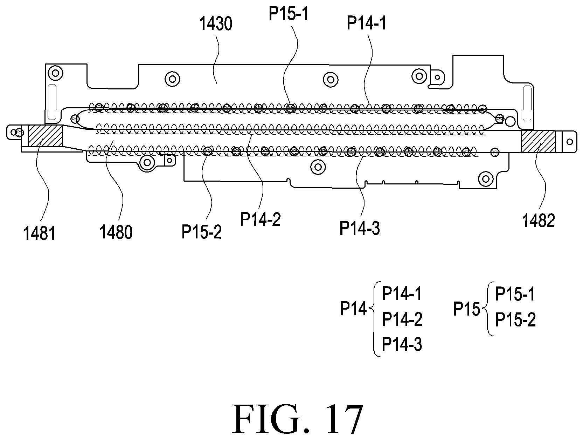

FIG. 17 is a diagram illustrating a heat-radiating member according to various embodiments of the disclosure.

Referring to FIG. 17, an electronic device (e.g., the electronic device 101 in FIGS. 14 to 15B or the electronic device 1300 in FIG. 16) may include a support member 1430 and a heat-radiating member 1480 disposed inside a housing (e.g., the housing 1200 in FIGS. 14 to 15B or the housing 1310 in FIG. 16).

According to an embodiment, the support member 1430 may be disposed such that at least a portion thereof faces a display (e.g., the display 1310 in FIG. 16). The support member 1430 may include a metal material (e.g., aluminum (Al), copper (Cu), or stainless steel (SUS)).

According to an embodiment, at least a portion of the heat-radiating member 1480 may be disposed and/or coupled to the support member 1430. According to an embodiment, the heat-radiating member 1480 may be configured to transfer heat generated from at least one heat source (not shown) to another electrical component (e.g., the battery 189 in FIG. 1). The heat-radiating member 1480 may include a metal material (e.g., copper (Cu)).

According to an embodiment, the heat-radiating member 1480 may include a plurality of heat sinks 1481 and 1482. At least one of the plurality of heat sinks 1481 and 1482 may be connected to the heat source, and the remainder of the plurality of heat sinks 1481 and 1482 may be connected to other electrical components (e.g., the battery 189 in FIG. 1). The plurality of heat sinks 1481 and 1482 may include a metal material (e.g., aluminum (Al)).

According to an embodiment, at least a portion of the heat-radiating member 1480 may be coupled to the support member 1430 by wobble laser welding P14 and spot laser welding P15.

According to an embodiment, the wobble laser welding P14 may include a first wobble laser welding P14-1 that couples at least a portion of one area (top area in FIG. 17) of the heat-radiating member 1480 to the support member 1430, a second wobble laser welding P14-2 that couples at least a portion of the central area (e.g., the area between top area and the bottom area in FIG. 17) of the heat-radiating member 1480 to the support member 1430, and a third wobble laser welding P14-3 that couples at least a portion of the other area (e.g., the bottom area in FIG. 17) of the heat-radiating member 1480 to the support member 1430.

According to an embodiment, the spot laser welding P15 may include the first spot laser welding P15-1 performed at a position overlapping the first wobble laser welding P14-1, and the second spot laser welding P15-2 performed at a position overlapping the third wobble laser welding P14-3.

According to various embodiments of the disclosure, an electronic device (e.g., the electronic device 200 in FIGS. 2 to 4) may include a housing (e.g., the housing 210 in FIGS. 2 to 3); a display (e.g., the display 220 in FIG. 4) disposed in the housing; a support member (e.g., the support member 232 in FIG. 4 or the support member 330 in FIGS. 5A to 6B) configured to support the display and including a first surface (e.g., the first surface 330a in FIGS. 5A to 6B) facing the display, a second surface (e.g., the second surface 330b in FIGS. 5A to 6B) facing in the opposite direction to the first surface, and a first opening (e.g., the first opening 332 in FIGS. 5A to 6B) formed to penetrate at least a portion of the first surface and the second surface; a battery (e.g., the battery 350 in FIGS. 5A to 6B) disposed on the second surface of the support member and having at least a portion facing the first opening; a printed circuit board (e.g., the printed circuit board 341 in FIGS. 5A to 6B) disposed on the second surface of the support member and spaced apart from the battery; and a heat-radiating member (e.g., the heat-radiating member 380 in FIGS. 5A to 6B) configured to mediate heat transfer between the display and the printed circuit board, and including a first area (e.g., the first area 381 in FIG. 7) having at least a portion disposed to overlap the first surface and a second area (e.g., the second area 381 in FIG. 7) coupled to the first area and having at least a portion disposed in the first opening, wherein at least a portion of the first area may be coupled to the support member by laser welding (e.g., the laser welding P1 in FIG. 8).

According to various embodiments, the display may have at least a portion in contact with the first area.

According to various embodiments, the electronic may further include at least one heat source (e.g., the heat source 360 in FIG. 7) disposed on the printed circuit board, and heat generated from the printed circuit board or the at least one heat source may be configured to be transmitted to the display or to the support member through the first area.

According to various embodiments, the at least one heat source may have at least a portion disposed to face at least a portion of the second area with the support member interposed therebetween.

According to various embodiments, the at least one heat source may have at least a portion in contact with the second area.

According to various embodiments, the second area may include a first portion coupled to the first area, and a second portion connected to the first portion and spaced apart from the first area.

According to various embodiments, the second portion may include at least a portion disposed to be spaced apart from the battery, and another portion, other than the at least a portion of the second portion, disposed to face the at least one heat source with the support member interposed therebetween.

According to various embodiments, the second portion may include at least a portion spaced apart from the battery, and another portion, other than the at least a portion of the second portion, in contact with the at least one heat source.

According to various embodiments, the laser welding may include at least one of wobble laser welding (e.g., the wobble laser welding P11 in FIG. 13C) or spot laser welding (e.g., the spot laser welding P12 or P13 in FIG. 13C).

According to various embodiments, the first area may include a (1-1)th area (e.g., the (1-1)th area 481a in FIG. 11B) seated on at least a portion of the first surface, and the (1-1)th area may have at least a portion coupled to the at least a portion of the first surface by laser welding.

According to various embodiments, the second area may include a (2-1)th area (e.g., the (2-1)th area 583a in FIG. 12A) disposed between the (1-1)th area and the at least a portion of the first surface, and the (2-1)th area may have at least a portion coupled to the (1-1)th area and the at least a portion of the first surface by laser welding.

According to various embodiments, at least a portion of edges of the (1-1)th area may be coupled to the first surface by laser welding (e.g., the laser welding P4 in FIG. 12A).

According to various embodiments, the second area may include a (2-1)th area disposed between the (1-1)th area and the at least a portion of the first surface, and at least a portion of the edges of the (2-1)th area may be coupled to at least a portion of the edges of the (1-1)th area and the at least a portion of the first surface by laser welding (e.g., the laser welding P6 in FIG. 12B).

According to various embodiments, the first area may include a (1-1)th area seated on at least a portion of the inner side surface (e.g., the inner side surface 831a in FIG. 12D) of the support member surrounding the first opening, and the (1-1)th area may have at least a portion coupled to at least a portion of the inner side surface of the support member by laser welding.

According to various embodiments, the first opening may include a (1-1)th opening (e.g., the (1-1)th opening 432a in FIG. 10) disposed to face the battery, and a (1-2)th opening (e.g., the (1-2)th opening 432b in FIG. 10) extending from the (1-1)th opening and disposed to face the printed circuit board.

According to various embodiments of the disclosure, an electronic device (e.g., the electronic device 200 in FIGS. 2 to 4) may include: a housing (e.g., the housing 210 in FIGS. 2 to 3); a display (e.g., the display 220 in FIG. 4) disposed in the housing; a support member (e.g., the support member 232 in FIG. 4 or the support member 330 in FIGS. 5A to 6B) configured to support the display and including a first surface (e.g., the first surface 330a in FIGS. 5A to 6B) facing the display, a second surface (e.g., the second surface 330b in FIGS. 5A to 6B) facing in the opposite direction to the first surface, and a first opening (e.g., the first opening 332 in FIGS. 5A to 6B) formed to penetrate at least a portion of the first surface and the second surface; a battery (e.g., the battery 350 in FIGS. 5A to 6B) disposed on the second surface of the support member; a printed circuit board (e.g., the printed circuit board 341 in FIGS. 5A to 6B) disposed on the second surface of the support member and spaced apart from the battery; and a heat-radiating member (e.g., the heat-radiating member 380 in FIGS. 5A to 6B) configured to mediate heat transfer between the display and the printed circuit board, and including a first area (e.g., the first area 381 in FIG. 7) having at least a portion disposed to overlap the first surface and a second area (e.g., the second area 383 in FIG. 7) coupled to the first area and having at least a portion disposed in the first opening, wherein the first opening may include a (1-1)th opening (e.g., the (1-1)th opening 432a in FIG. 10) disposed to face the battery, and a (1-2)th opening (e.g., the (1-2)th opening 432b in FIG. 10) extending from the (1-1)th opening and disposed to face the printed circuit board, and wherein at least a portion of the first area may be coupled to the support member by laser welding (the laser welding P1 in FIG. 8), and the laser welding may include at least one of wobble laser welding (e.g., the wobble laser welding P11 in FIG. 13C) and spot laser welding (e.g., the spot laser welding P12 or P13 in FIG. 13C).

According to various embodiments, at least a portion of the edge of the first area may be coupled to the support member by the wobble laser welding, and at least a portion of the first area adjacent to the edge may be coupled to the support member by the spot laser welding.

According to various embodiments, at least one heat source (e.g., the heat source 360 in FIG. 7) disposed on the printed circuit board may be further included, and heat generated from the at least one heat source may be configured to be transmitted to the display or to the support member through the first area.

According to various embodiments, the at least one heat source may have at least a portion disposed to face at least a portion of the second area with the support member interposed therebetween.

According to various embodiments of the disclosure, a heat-radiating structure of the electronic device (e.g., the electronic device 200 in FIGS. 2 to 4) may include: a first electrical component (e.g., the display 220 in FIG. 4); a plurality of second electrical components (e.g., the heat source 360 and the battery 350 in FIG. 7) spaced apart from the first electrical component; a support member (e.g., the support member 330 in FIG. 7) including a first surface (e.g., the first surface 330a in FIG. 7) disposed to face the first electrical component and a second surface (e.g., the second dur 330b in FIG. 7) disposed to face the plurality of second electrical components; and a heat-radiating member (e.g., the heat-radiating member 380 in FIG. 7) configured to transfer heat generated from at least one (the heat source 360 in FIG. 7) of the plurality of second electrical components to the first electrical component (e.g., the display 220 in FIG. 4), wherein at least a portion of the heat-radiating member may be coupled to at least a portion of the first surface by laser welding (e.g., the laser welding P1 in FIG. 8).

As described above, although specific embodiments have been described in the detailed description of this document, it will be obvious to those skilled in the art that various modifications are possible without departing from the scope of this document.

### Annex to the Description

Certain exemplary embodiments of the present invention provide one or more electronic devices according to one or more of the following exemplary aspects.

In accordance with a first aspect, there is provided an electronic device comprising: a housing; a display disposed in the housing; a support member configured to support the display and including a first surface facing the display, a second surface facing in opposite direction to the first surface, and a first opening formed to penetrate at least a portion of the first surface and the second surface; a battery disposed on the second surface of the support member, wherein at least a portion of the battery faces the first opening; a printed circuit board disposed on the second surface of the support member and spaced apart from the battery; and a heat-radiating member configured to mediate heat transfer between the display and the printed circuit board, and comprising a first area, wherein at least a portion of which is disposed to overlap the first surface and a second area coupled to the first area, wherein at least a portion of which is disposed in the first opening. At least a portion of the first area is coupled to the support member by laser welding.

In accordance with a second aspect, there is provided an electronic device according to the first aspect, wherein at least a portion of the display contacts the first area.

In accordance with a third aspect, there is provided an electronic device according to the first aspect, further including at least one heat source disposed on the printed circuit board, wherein heat generated from the printed circuit board or the at least one heat source is configured to be transmitted to the display or to the support member through the first area.

In accordance with a fourth aspect, there is provided an electronic device according to the third aspect, wherein at least a portion of the at least one heat source is disposed to face at least a portion of the second area with the support member interposed therebetween.

In accordance with a fifth aspect, there is provided an electronic device according to the third aspect, wherein at least a portion of the at least one heat source contacts the second area.

In accordance with a sixth aspect, there is provided an electronic device according the third aspect, wherein the second area includes a first portion coupled to the first area, and a second portion connected to the first portion and spaced apart from the first area.

In accordance with a seventh aspect, there is provided an electronic device according to the sixth aspect, wherein at least a portion of the second portion is spaced apart from the battery, and wherein another portion of the second portion, other than the at least a portion of the second portion, is disposed to face the at least one heat source with the support member interposed therebetween.

In accordance with an eighth aspect, there is provided an electronic device according to the sixth aspect, wherein at least a portion the second portion is spaced apart from the battery, and wherein another portion of the second portion, other than the at least a portion of the second portion, contacts the at least one heat source.

In accordance with a ninth aspect, there is provided an electronic device according to the first aspect, wherein the laser welding includes at least one of wobble laser welding or spot laser welding.

In accordance with a tenth aspect, there is provided an electronic device according to the first aspect, wherein the first area includes a (1-1)th area seated on at least a portion of the first surface, and wherein at least a portion of the (1-1)th area is coupled to the at least a portion of the first surface by laser welding.

In accordance with an eleventh aspect, there is provided an electronic device according to the tenth aspect, wherein the second area includes a (2-1)th area disposed between the (1-1)th area and the at least a portion of the first surface, and wherein at least a portion of the (2-1)th area is coupled to the (1-1)th area and the at least a portion of the first surface by laser welding.

In accordance with a twelfth aspect, there is provided an electronic device according to the tenth aspect, wherein at least a portion of edges of the (1-1)th area is coupled to the first surface by laser welding.

In accordance with a thirteenth aspect, there is provided an electronic device according to the tenth aspect, wherein the second area includes a (2-1)th area disposed between the (1-1)th area and the at least a portion of the first surface, and wherein at least a portion of the edges of the (2-1)th area is coupled to at least a portion of the edges of the (1-1)th area and the at least a portion of the first surface by laser welding.

In accordance with a fourteenth aspect, there is provided an electronic device according to the first aspect, wherein the first area includes a (1-1)th area seated on at least a portion of an inner side surface of the support member surrounding the first opening, and wherein at least a portion of the (1-1)th area is coupled to at least a portion of the inner side surface of the support member by laser welding.

In accordance with a fifteenth aspect, there is provided an electronic device according to the first aspect, wherein the first opening includes a (1-1)th opening disposed to face the battery, and a (1-2)th opening extending from the (1-1)th opening and disposed to face the printed circuit board.

## Claims

1. An electronic device (101, 200, 300, 1300) comprising:
a housing (210, 1200, 1310);
a display (220, 1320) disposed in the housing;
a support member (232, 330, 430, 530, 630, 730, 830, 930, 1030, 1430) including a first surface facing the display, a second surface facing in opposite direction to the first surface, and an opening formed to penetrate at least a portion of the first surface and the second surface;
a battery (250, 350, 450) disposed on the second surface of the support member, wherein at least a portion of the battery overlaps a first portion of the opening;
a printed circuit board (240, 341, 441), including at least one heat source (360, 460), disposed in the housing and spaced apart from the battery, wherein at least a portion of the at least one heat source overlaps a second portion extending from the first portion of the opening; and
a heat-radiating member (380, 480, 580, 680, 780, 880, 980, 1080, 1480) configured to transfer heat generated by the at least one heat source, and comprising a first area (381) and a second area (383) coupled to the first area, wherein a portion of the first area is disposed to overlap the first surface and wherein at least a portion of the second area is disposed in the opening,
wherein the portion of the first area is coupled to the support member by laser welding or an another portion of the second area and the portion of the first area are coupled to the support member by laser welding.

2. The electronic device (101, 200, 300, 1300) of claim 1, wherein the laser welding includes spot laser welding.

3. The electronic device (101, 200, 300, 1300) of claim 2, wherein a plurality of points formed by the spot laser welding are arranged in one row.

4. The electronic device (101, 200, 300, 1300) of any one of claims 1 to 3, wherein the battery (250, 350, 450) is spaced apart from the heat-radiating member, and a space is formed between the battery and the second area of the heat-radiating member.

5. The electronic device (101, 200, 300, 1300) of claim 4, further comprising:
an adhesive member disposed between at least a portion of the battery and at least a portion of the second surface of the support member,
wherein the space is disposed between a first portion of the adhesive member and a second portion of the adhesive member.

6. The electronic device (101, 200, 300, 1300) of any one of claims 1 to 5, wherein an edge of the first area of the heat-radiating member is disposed on a stepped portion (334) of the support member recessed from the first surface of the support member.

7. The electronic device (101, 200, 300, 1300) of claim 6, wherein at least a portion of the edge of the first area of the heat-radiating member is coupled to the stepped portion of the support member by the laser welding.

8. The electronic device (101, 200, 300, 1300) of any one of claims 1 to 5, wherein at least a portion of an edge of the first area of the heat-radiating member is coupled to the first surface of the support member by the laser welding.

9. The electronic device (101, 200, 300, 1300) of claim 8, wherein an edge of the second area of the heat-radiating member is disposed between the edge of the first area of the heat-radiating member and the first surface of the support member.

10. The electronic device (101, 200, 300, 1300) of claim 9, wherein the edge of the second area of the heat-radiating member is coupled to the edge of the first area of the heat-radiating member and the first surface of the support member by the laser welding.

11. The electronic device (101, 200, 300, 1300) of claim 8, wherein the edge of the second area of the heat-radiating member is coupled to the edge of the first area of the heat-radiating member and is not coupled to the first surface of the support member.

12. The electronic device (101, 200, 300, 1300) of any one of claims 1 to 11, wherein the heat-radiating member includes a vapor chamber.

13. The electronic device (101, 200, 300, 1300) of any one of claims 1 to 12, wherein the vapor chamber includes a copper.

14. The electronic device (101, 200, 300, 1300) of any one of claims 1 to 13, wherein the support member includes an aluminum material.
